(19) Europäisches Patentamt
European Patent Office
Office européen des brevets

(11) Veröffentlichungsnummer: **0 453 950 A2**

(12) # EUROPÄISCHE PATENTANMELDUNG

(21) Anmeldenummer: **91106179.4**

(51) Int. Cl.[5]: **G03F 7/023**

(22) Anmeldetag: **18.04.91**

(30) Priorität: **27.04.90 DE 4013575**

(43) Veröffentlichungstag der Anmeldung: **30.10.91 Patentblatt 91/44**

(84) Benannte Vertragsstaaten: **BE DE FR GB IT NL**

(71) Anmelder: **BASF Aktiengesellschaft
Carl-Bosch-Strasse 38
W-6700 Ludwigshafen(DE)**

(72) Erfinder: **Roser, Joachim, Dr.
Saarlandstrasse 40
W-6700 Ludwigshafen(DE)**

(54) **Verfahren zur Herstellung negativer Reliefkopien.**

(57) Herstellung negativer Reliefkopien durch bildmäßige Belichtung einer Aufzeichnungsplatte aus einem Träger und einer darauf aufgebrachten lichtempfindlichen Schicht, die als lichtempfindliche Verbindungen Ester der 1,2-Naphthochinon-2-diazid-4- und/oder 5-sulfonsäure oder -carbonsäure enthalten, Erhitzen der belichteten Platte, vollflächiges Belichten der Platte und Entwickeln der Reliefkopie durch Herauslösen der alkalilöslichen Bestandteile aus der Aufzeichnungsschicht mittels einer wäßrig-alkalischen Entwicklerlösung, indem die lichtempfindliche Schicht der Aufzeichnungsplatte ein Umsetzungsprodukt aus

a) 50 bis 99 Gew.-% eines oligomeren oder polymeren Kondensationsproduktes aus

$a_1$) 0,5 bis 1 mol eines alkyl- und/oder alkoxysubstituierten ein- bis dreiwertigen Hydroxybenzols,

$a_2$) 0 bis 0,5 mol Phenol und

$a_3$) 0,5 bis 1,5 mol einer $C_1$-$C_{12}$-Carbonylverbindung,

wobei die Summe der Mengen von $a_1$) und $a_2$) 1 mol beträgt, und

b) 1 bis 50 Gew.-% 1,2-Naphthochinon-2-diazid-4-sulfonsäure oder -carbonsäure oder einem funktionellen Derivat dieser Säuren,

wobei bis zu 20 Gew.-% dieser Verbindungen durch die entsprechenden Ester der 5-Sulfon- oder -Carbonsäure ersetzt sein können,
enthält.

EP 0 453 950 A2

Die vorliegende Erfindung betrifft ein verbessertes Verfahren zur Herstellung negativer Reliefkopien durch bildmäßige Belichtung einer Aufzeichnungsplatte aus einem Träger und einer darauf aufgebrachten lichtempfindlichen Schicht, die als lichtempfindliche Verbindungen Ester der 1,2-Naphthochinon-2-diazid-4- und/oder 5-sulfonsäure oder -carbonsäure enthalten, Erhitzen der belichteten Platte, vollflächiges Belichten der Platte und Entwickeln der Reliefkopie durch Herauslösen der alkalilöslichen Bestandteile aus der Aufzeichnungsschicht mittels einer wäßrig-alkalischen Entwicklerlösung.

Druckplatten, welche als lichtempfindliche Verbindungen Ester der 1,2-Naphthochinon-2-diazid-4- und/oder 5-sulfonsäure oder -carbonsäure enthalten, sind allgemein bekannt, z.B. aus der DE-A 33 25 023.

Bei der Belichtung der lichtempfindlichen Schicht wandeln sich die 1,2-Naphthochinon-2-diazid-4-sulfonsäureester in die Indencarbonsäurederivate um:

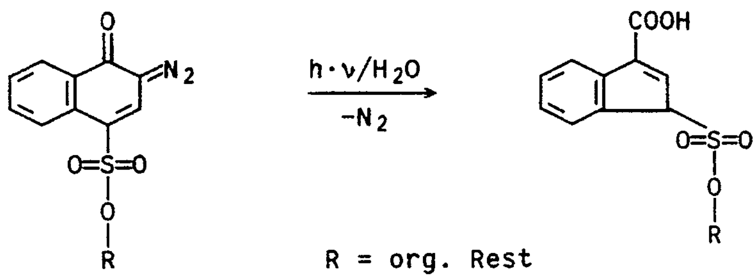


Dadurch werden diese lichtempfindlichen Verbindungen wasserlöslich und können zusammen mit den in wäßrig-alkalischen Lösungen löslichen Bindemitteln aus den belichteten Stellen bei der Entwicklung ausgewaschen werden. An diesen Stellen wird somit die Aluminiumoxidschicht der Trägerplatte freigelegt. Diese Bereiche nehmen das Wasser der Emulsion aus Wasser und Druckfarbe auf, wogegen die Druckfarbe die verbliebene organische Schicht benetzt.

Eine wichtige Variante der Herstellung derartiger Druckplatten besteht darin, auf der Basis von 1,2-Naphthochinondiaziden beruhende positiv arbeitende lichtempfindliche Schichten durch eine bestimmte Folge von Behandlungsschritten negativ zu verarbeiten. Bei diesem Umkehrverfahren wird die Druckplatte nach der bildmäßigen Belichtung zunächst erhitzt, wobei eine Decarboxylierung des im Belichtungsschritt gebildeten Indencarbonsäurederivates eintritt, und dann erneut, jedoch vollflächig, also ohne Vorlage belichtet. Anschließend wird wäßrig-alkalisch entwickelt, wobei die im ersten Belichtungsschritt bildmäßig belichteten Stellen stehenbleiben und die übrigen Schichtbereiche ausgewaschen werden.

Erwünscht sind Aufzeichnungsplatten, die sich wahlweise zu einer Positiv- oder einer Negativ-Kopie einer Vorlage verarbeiten lassen, so daß die beiden Arbeitsweisen auf ein und derselben Druckplatte im sogenannten Fotocomposing-Verfahren kombiniert werden können.

Derartige umkehrfähige Kopierschichten auf der Basis von 1,2-Naphthochinon-2-diazid-5-derivaten, die Hydroxyl- oder Amino-Gruppen enthaltende Zusätze zur Härtung der im Erwärmungsschritt gebildeten Negativ-Schicht aufweisen, sind z.B. aus der DE-A 24 61 912 und der GB-A 1 492 620 bekannt. Diese Zusätze haben jedoch einen nachteiligen Einfluß auf die Lagerfähigkeit der Kopierschichten und auf bestimmte kopiertechnische Eigenschaften, z.B. die Lichtempfindlichkeit und den Bildkontrast nach dem Belichten.

Zur Vermeidung derartiger Nachteile werden in der DE-A 33 25 023 1,2-Naphthochinon-2-diazid-4-sulfonsäureester oder -4-carbonsäureester empfohlen, da bei ihnen im Gegensatz zu den in 5-Position funktionalisierten Derivaten die bestrahlten Schichtbereiche bei erhöhter Temperatur auch ohne Zusätze ausgehärtet und damit entwicklerunlöslich werden.

Als entsprechende Alkoholkomponenten wurden Monomere wie z.B. 2,3,4-Trihydroxybenzophenon und 4-(2-Phenyl-prop-2-yl)phenol oder Polymere wie Phenol-Aldehyd- oder Phenol-Aceton-Kondensationsprodukte vorgeschlagen.

Doch auch die Verwendung der polymeren Ester auf der Basis von Phenol-Harzen ist bezüglich der geforderten Eigenschaften der daraus erhältlichen Druckplatten nicht gänzlich befriedigend. So wird die Forderung nach einem ausgewogenen Verhältnis zwischen guter Auflagenbeständigkeit und guter mechanischer Stabilität der Schicht sowie genügend großem Auflösevermögen der Negativ-Kopie in Verbindung mit einem großen Tonwertübertragungsbereich und insbesondere eine gute Entwickelbarkeit durch leichte Auswaschbarkeit nicht hinreichend erfüllt.

Der Erfindung lag daher die Aufgabe zugrunde, lichtempfindliche Umsetzungsprodukte bereitzustellen, die sich besser für die Herstellung von umkehrfähigen Druckplatten mit optimalen Anforderungsprofilen

eignen als die bisher bekannten Verbindungen.

Demgemäß wurde ein verbessertes Verfahren zur Herstellung negativer Reliefkopien durch bildmäßige Belichtung einer Aufzeichnungsplatte aus einem Träger und einer darauf aufgebrachten lichtempfindlichen Schicht, die als lichtempfindliche Verbindungen Ester der 1,2-Naphthochinonen-2-diazid-4- und/oder 5-sulfonsäure oder -carbonsäure enthalten, Erhitzen der belichteten Platte, vollflächiges Belichten der Platte und Entwickeln der Reliefkopie durch Herauslösen der alkalilöslichen Bestandteile aus der Aufzeichnungsschicht mittels einer wäßrig-alkalischen Entwicklerlösung gefunden, welches dadurch gekennzeichnet ist, daß die lichtempfindliche Schicht der Aufzeichnungsplatte ein Umsetzungsprodukt aus

a) 50 bis 99 Gew.-% eines oligomeren oder polymeren Kodensationsproduktes aus

$a_1$) 0,5 bis 1 mol eines alkyl- und/oder alkoxysubstituierten ein- bis dreiwertigen Hydroxybenzols,

$a_2$) 0 bis 0,5 mol Phenol und

$a_3$) 0,5 bis 1,5 mol einer $C_1$-$C_{12}$-Carbonylverbindung,

wobei die Summe der Mengen von $a_1$) und $a_2$) 1 mol beträgt, und

b) 1 bis 50 Gew.-% 1,2-Naphthochinon-2-diazid-4-sulfonsäure oder -carbonsäure oder einem funktionellen Derivat dieser Säuren, wobei bis zu 20 Gew.-% dieser Verbindungen durch die entsprechenden Ester der 5-Sulfon- oder -Carbonsäure ersetzt sein können,

enthält.

Des weiteren wurden neue lichtempfindliche Aufzeichnungsmaterialien gefunden.

Die erfindungsgemäß zu verwendenden Umsetzungsprodukte enthalten 50 bis 99 Gew.-% eines oligomeren oder polymeren Kondensationsproduktes als Komponente a) und 1 bis 50 Gew.-% 1,2-Naphthochinon-2-diazid-4-sulfonsäure oder -carbonsäure oder ein funktionelles Derivat dieser Säuren als Komponente b), wobei bis zu 20 Gew.-% dieser Verbindungen durch die entsprechenden Ester der 5-Sulfon- oder -Carbonsäure ersetzt sein können.

Die Komponente a) besteht ihrerseits aus 0,5 bis 1 mol eines alkyl- und/oder alkoxysubstituierten ein- bis dreiwertigen Hydroxybenzols als Komponente $a_1$) und 0,5 bis 1,5 mol, vorzugsweise 0,8 bis 1,2 mol einer Carbonylverbindung, besonders einer $C_1$-$C_{12}$-Carbonylverbindung, als Komponente $a_3$).

Außerdem kann das Kondensationsprodukt a) bis zu 0,5 mol Phenol als Komponente $a_2$) enthalten, wobei die Summe der Mengen der Komponenten $a_1$) und $a_2$) 1 mol beträgt.

Als Komponente $a_1$) eignen sich alkyl- und/oder alkoxysubstituierte ein- bis dreiwertige Hydroxybenzole, wobei die Anzahl der C-Atome in diesen Substituenten vorzugsweise je 1 bis 12 beträgt. Besonders bevorzugte Komponenten $a_1$) sind p-Kresol und p-tert.-Butylphenol. Bevorzugt sind m-Kresol, 4-Octylphenol, m-Methoxyphenol, p-Methoxyphenol, m-Butoxyphenol und p-Butoxyphenol. Weiterhin eignen sich Resorcin, Pyrogallol, Pyrogallolmonomethylether und Pyrogalloldimethylether.

Als Komponente $a_3$) kommen besonders $C_1$-$C_{12}$-Carbonylverbindungen in Betracht. Besonders gute Ergebnisse erzielt man mit Formaldehyd. Bevorzugt sind Benzaldehyd, Acetaldehyd und Isobutyraldehyd. Daneben sind Aceton und Acetophenon zu nennen.

Als Komponente b) kommen 1,2-Naphthochinon-2-diazid-4-sulfonsäure oder -carbonsäure oder funktionelle Derivate dieser Säuren in Betracht, wobei bis zu 20 Gew.-% dieser Verbindungen durch die entsprechenden Ester der 5-Sulfon- oder -Carbonsäure ersetzt sein können.

Als funktionelle Säurederivate eignen sich Amide und Halogenide, insbesondere Chloride.

Außer den gemäß der Erfindung zu verwendenden Umsetzungsprodukten enthalten die lichtempfindlichen Aufzeichnungsschichten polymere, wasserunlösliche, in wäßrig-alkalischen Lösungen lösliche harzartige Bindemittel.

Besonders bevorzugt sind Novolak-Kondensationsprodukte von Formaldehyd mit Phenol, m-Kresol und p-Kresol. Bevorzugt sind Kondensationsharze von Formaldehyd mit p-Methoxyphenol, 4-Octylphenol oder p-tert.-Butylphenol und Phenol und/oder Kresol als weiteren Komponenten. Daneben sind Kondensationsprodukte von Acetaldehyd, Isobutyraldehyd oder Benzaldehyd mit Phenol, m-Kresol und p-Kresol zu nennen.

Die Novolake können in bekannter Weise durch Umsetzung eines Teils ihrer Hydroxygruppen z.B. mit Chloressigsäure, Isocyanaten, Epoxiden oder Carbonsäureanhydriden modifiziert sein.

Als Bindemittel eignen sich weiterhin Polyhydroxyphenolharze, die durch Kondensation von Phenolen mit Aldehyden oder Ketonen hergestellt werden, Mischpolymerisate aus Styrol und Maleinsäureanhydrid, Polyvinylphenole und Mischpolymerisate der Acrylsäure oder Methacrylsäure, insbesondere mit Acryl- oder Methacrylsäure-$C_1$-$C_{12}$-alkylestern.

Die zu verwendenden Bindemittel haben vorzugsweise einen Erweichungspunkt im Bereich von 90 bis 160 °C und werden im allgemeinen in Mengen von 15 bis 95 Gew.-%, vorzugsweise von 50 bis 80 Gew.-% eingesetzt, bezogen auf den Gesamtfeststoffanteil der Schicht.

Neben den lichtempfindlichen Umsetzungsprodukten und den Bindemitteln können die Aufzeichnungsschichten noch Hilfsstoffe enthalten.

So können zusätzliche Harze zur Abstimmung auf spezielle Entwicklerlösungen mitverwendet werden, bevorzugt Epoxyharze und Homo- und Copolymerisate des Vinylacetats, des N-Vinylpyrrolidons, von Acrylsäureestern, von Vinylacetalen und von Vinylethern.

Zweckmäßigerweise werden diese Harze in Mengen von 0,1 bis 10 Gew.-%, bezogen auf den Gesamtfeststoffanteil der Schicht, eingesetzt.

Weiterhin können die lichtempfindlichen Aufzeichungsschichten monomere oder polymere 1,2-Naphthochinon-2-diazid-5-sulfonsäureester zur Verbesserung verschiedener Verarbeitungseigenschaften in der Kopie oder beim Druck enthalten, z.B. des in der Kopie übertragbaren Tonwertumfangs oder des Farbannahme- und Freilaufverhaltens.

Bevorzugt sind monomere Veresterungsprodukte von Naphthochinon-(1,2)-diazid(2)-5-sulfonsäurechlorid mit 2,5-di-tert.-butyl-4-methylphenol, 4-Methylphenol oder Phenol sowie das polymere Veresterungsprodukt mit einem 4-Octylphenol-Formaldehyd-Kondensat.

Im allgemeinen werden diese Ester in Mengen von 0,05 bis 15 Gew.-% eingesetzt, bezogen auf den Gesamtfeststoffanteil der Schicht.

Ferner können der lichtempfindlichen Schicht Farbstoffe, z.B. Azo-, Anthrachinon-, Cyanin- oder Phthalocyaninfarbstoffe, insbesondere säure- oder lichtempfindliche Farbstoffe, z.B. Triphenylmethanfarbstoffe oder Azobenzolderivate, zugesetzt werden.

Bei Einsatz von säureempfindlichen Farbstoffen können photochemische Säurespender zugesetzt werden, die beim Belichten vorzugsweise starke Säuren bilden bzw. abspalten und in einer Folgereaktion mit dem Farbstoff einen Farbumschlag bewirken.

Die Mitverwendung eines Farbumschlagsystems gestattet eine Überprüfung des Kopierergebnisses durch Augenschein anhand des resultierenden sogenannten latenten Bildes.

Die Farbstoffe werden zweckmäßigerweise in Mengen von 0,05 bis 5 Gew.-% eingesetzt.

Als photochemische Säurespender eignen sich chromophor-substituierte Halogenmethylderivate des Triazins, des Oxdiazols und des Thiadiazols sowie Aryl-Diazoniumsalze, Aryl-Sulfonium-Salze und Aryl-Iodoniumsalze.

Besonders bevorzugt sind 2-(4-Methoxyphenyl)-4,6- bis -trichlormethyl-1,3,5-triazin, 2-(4-Methoxy-naphth-1-yl)-4,6- bis -trichlormethyl-1,3,5-triazin, 2-Trichlormethyl-5-($\beta$-(2'-benzofuranyl)vinyl)-1,3,4-oxdiazol, 4-Phenylamino-benzol-diazonium-tetrafluoroborat und 4-(4'-Methylphenylthio)-2,5-diethoxybenzol-diazonium-hexafluorophosphat.

Im allgemeinen werden die photochemischen Säurespender in Mengen von 0,05 bis 5 Gew.-% eingesetzt, bezogen auf den Gesamtfeststoffanteil der Schicht.

Ferner können den Schichten noch zur Verbesserung der Entwickelbarkeit dienende Hilfsstoffe wie Carbonsäureanhydride, Phosphor- oder Phosphonsäure-Derivate beigefügt werden.

Besonders bevorzugt ist Glutarsäureanhydrid, das in Mengen von 0,05 bis 5 Gew.-% eingesetzt wird, bezogen auf den Gesamtfeststoffanteil der Schicht.

Zur Beschichtung eines Trägers wird die lichtempfindliche Schicht in einem Lösungsmittel gelöst, wobei bevorzugt 5 bis 35 %ige Lösungen hergestellt werden.

Geeignete Lösungsmittel sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether, Ester wie Butylacetat und Lactone wie Butyrolaoton sowie Mischungen dieser Lösungsmittel.

Besonders bevorzugt sind Ethylen- und Propylenglykolmonomethylether und deren Gemische mit Aceton.

Als Trägermaterialien für die lichtempfindliche Schicht dienen walzblanke, mechanisch oder elektrochemisch aufgerauhte, anodisierte Aluminiumbleche, die zudem noch chemisch mit hydrophilierenden wäßrigen Lösungen, z.B. mit Polyvinylphosphonsäure, Silikaten, Phosphaten, Hexafluorozirkonaten oder mit hydrolisiertem Tetraethylorthosilikat, vorbehandelt sein können.

Die Beschichtung des Trägermaterials erfolgt in an sich bekannter Weise durch Aufschleudern, Sprühen, Tauchen oder Walzen und wird so vorgenommen, daß nach der Trocknung auf einen Restlösungsmittelgehalt von weniger als 5 Gew.-% ein Schichtgewicht von 1,0 bis 3,5 g/$m^2$ resultiert.

Zum Entwickeln werden wäßrige Lösungen alkalischer Substanzen, z.B. von Alkaliphosphaten, -silikaten, -carbonaten oder -hydroxiden verwendet.

Besonders bevorzugt sind 2 bis 5%ige wäßrig-alkalische Natriumsilikatlösungen.

Ganz besonderer Bedeutung ist denjenigen lichtempfindlichen Aufzeichnungsmaterialien beizumessen, in denen das oligomere oder polymere Kondensationsprodukt a), welches fest durch Esterbildung mit der 1,2-Naphthochinon-2-diazidverbindung verankert ist, zusätzlich die Funktion des Bindemittels übernimmt.

Diese Aufzeichnungsmaterialien sind neu. Durch die Wahl dieser Esterkomponente a) ist der Zusatz eines gesonderten Bindemittels zwar möglich, aber nicht mehr notwendig.

Verfahrenstechnisch geht man zur Herstellung negativer Reliefkopien in der Regel so vor, daß man die Aufzeichnungsplatte bildmäßig belichtet, danach erhitzt und nach Abkühlung erneut, jedoch vollflächig und ohne Vorlage belichtet und anschließend wäßrig-alkalisch entwickelt.

Die Bestrahlung kann mit verschiedenen Strahlungsquellen erfolgen, z.B. mit UV-, Metallhalogenid-, Xenon- oder Bogenlampen. Die Bestrahlungszeiten betragen für die bildmäßige Belichtung normalerweise 5 bis 150, meistens 30 bis 80 Sekunden.

Das sich anschließende Erhitzen wird üblicherweise im Bereich von 80 bis 160° C, vorzugsweise von 110 bis 150° C durchgeführt. Die Dauer des Erhitzens liegt im allgemeinen zwischen 0,5 und 10 Minuten. Es kann z.B. durch Bestrahlung, Konvektion, durch Kontakt mit erwärmten Flächen wie Walzen oder durch Tauchen in ein erwärmtes Bad einer inerten Flüssigkeit erfolgen.

Nach Abkühlung der Platte wird diese einer Totalbelichtung unterworfen, wobei die Belichtungsdauer üblicherweise im Bereich von 30 bis 80 Sekunden liegt.

Diese Nachbelichtung kann vorzugsweise unter der gleichen Lichtquelle erfolgen, die zur Bildbelichtung verwendet wurde.

Die wäßrig-alkalische Entwicklung kann unmittelbar auf die Nachbelichtung folgen oder auch in zeitlichem Abstand von z.B. mehreren Stunden vorgenommen werden.

Wirtschaftlich sehr vorteilhaft ist die Kombination dieses Verfahrens zur Herstellung negativer Kopien mit dem Verfahren zur Herstellung positiver Kopien auf ein und derselben Druckplatte nach dem sogenannten Fotocomposing-Prozeß.

Hierzu wird beispielsweise eine Hälfte der Platte abgedeckt und auf der anderen Hälfte bildmäßig durch eine Positiv-Vorlage belichtet, dann erwärmt, danach die zuvor abgedeckte Hälfte bildmäßig, die zuvor nicht abgedeckte Hälfte vollflächig belichtet und schließlich wäßrig-alkalisch entwickelt.

Die nach diesem Fotocomposing-Prozeß erhaltenen Druckplatten weisen die Negativ-Kopie der Vorlage auf der zuerst bildmäßig belichteten Plattenhälfte und die Positiv-Kopie auf der anderen Hälfte auf.

Das erfindungsgemäße Verfahren kann zur Herstellung von Druckplatten für den Hoch-, Tief- und Flachdruck sowie von Photoresistschablonen für die Leiterplattenherstellung eingesetzt werden.

Die gemäß der Erfindung zu verwendenden Umsetzungsprodukte und die daraus erhältlichen Druckplatten zeichnen sich durch ihre hervorragende Eignung für die wahlweise Herstellung positiver oder negativer Kopien aus.

Beispiele

Herstellung negativer Reliefkopien

Eine 10 %ige Lösung eines Gemisches aus

- einem Bindemittel oder Bindemittelgemisch B
- eines oder mehrerer 4-Sulfonsäureester des 1,2-Naphthochinon-2-diazids E-4
- eines oder mehrerer 5-Sulfonsäureester des 1,2-Naphthochinon-2-diazids E-5
- eines strahlungsempfindlichen Farbstoffsystems aus
  - einem oder mehreren Farbstoffen F und
  - einem oder mehreren Säurespendern S und
- Hilfsstoffen H

in den in der Tabelle genannten Mengen in einem Lösungsmittel L wurde auf eine elektrolytisch aufgerauhte und anodisierte Aluminiumträgerplatte mit einem Schichtgewicht von 1,6 bis 2,5 $g/m^2$ aufgetragen. Die Platte wurde bildmäßig durch eine Positiv-Vorlage, welche Präzisionsmeßstreifen (FOGRA-Meßstreifen PMS-I, UGRA-Offset-Testkeil 1982) enthielt, für die Dauer von 10 bis 112 Sekunden mit einer Metallhalogenid-Lampe von 5,5 kW und einem Lampenabstand von ca. 70 cm belichtet. Anschließend wurde 90 Sekunden auf 125 bis 145° C erhitzt. Danach wurde vollflächig durch eine transparente Folie 30 bis 80 Sekunden belichtet. Schließlich wurde mit einer 2 bis 5 %igen wäßrig-alkalischen Natriumsilikatlösung bei 15 bis 30° C entwickelt.

Die erhaltenen Druckplatten wiesen die Negativ-Kopie der Vorlage auf.

Die Bewertung der Kopien der FOGRA-Teststreifen erfolgte in an sich bekannter Weise nach der in FOGRA-Praxis-Report Nr. 34, München 1985 beschriebenen Methodik.

In allen Fällen wurden mit den so hergestellten Druckformen einwandfreie Offset-Drucke erhalten.

Die Einzelheiten der Versuche sind der nachstehenden Tabelle zu entnehmen.

Bedeutung der Abkürzungen in der Tabelle

Bindemittel B

| | |
|---|---|
| B/1 | Phenol/p-Kresol/m-Kresol-Formaldehyd-Kondensat, Erweichungspunkt 120,5 °C nach DIN 52 011 |
| B/2 | p-Methoxyphenol-Formaldehyd-Kondensat, Erweichungspunkt 134 °C nach DIN 52 011 |
| B/3 | Phenol/4-Octylphenol-Formyldehyd-Kondensat, Erweichungspunkt 104 °C nach DIN 52 011 |
| B/4 | Phenol/Kresol/p-Methoxyphenol-Formaldehyd-Kondensat, Erweichungspunkt 157 °C nach DIN 52 011 |
| B/5 | Phenol/p-Kresol/m-Kresol-Acetaldehyd-Kondensat, Erweichungspunkt 92 °C, nach DIN 52 011 |
| B/6 | Phenol/p-Kresol/m-Kresol-Isobutyraldehyd-Kondensat, Erweichungspunkt 123,5 °C nach DIN 52 011 |
| B/7 | Phenol/p-Kresol/m-Kresol-Benzaldehyd-Kondensat, Erweichungspunkt 142,5 °C nach DIN 52 011 |
| B/8 | Phenol/Kresol/p-tert.-Butylphenol-Formaldehyd-Kondensat, Erweichungspunkt 100 °C nach DIN 52 011 |
| B/9 | Phenol/p-Methoxyphenol-Formaldehyd-Kondensat, Erweichungspunkt 117 °C nach DIN 52 011 |
| B/10 | p-Kresol-Formaldehyd-Kondensat, Erweichungspunkt 92 °C nach DIN 52 011. |

Ester E-4

| | |
|---|---|
| E-4/1 | Veresterungsprodukt aus Naphthochinon-(1,2)-diazid-(2)-4-sulfonsäurechlorid und einem p-Kresol-Formaldehyd-Kondensat, Erweichungspunkt 160 °C |
| E-4/2 | Veresterungsprodukt aus Napthochinon-(1,2)-diazid-(2)-4-sulfonsäurechlorid und einem p-tert.-Butylphenol-Formaldehyd-Kondensat, Erweichungspunkt 130 °C |
| E-4/3 | Veresterungsprodukt aus Naphthochinon-(1,2)-diazid-(2)-4-sulfonsäurechlorid und einem Phenol/Kresol/tert.-Butylphenol-Formaldehyd-Kondensat, Erweichungspunkt 125 °C |
| E-4/4 | Veresterungsprodukt aus Naphthochinon-(1,2)-diazid-(2)-4-sulfonsäurechlorid und einem Phenol/m-Kresol/p-Kresol-Benzaldehyd-Kondensat, Erweichungspunkt 135 °C. |

Ester E-5

| | |
|---|---|
| E-5/1 | Naphthochinon-(1,2)-diazid-(2)-5-sulfonsäure-(2,5-di-tert.-butyl-4-methyl)phenylester |
| E-5/2 | Veresterungsprodukt aus Napthochinon-(1,2)-diazid-(2)-5-sulfonsäurechlorid und einem 4-Octylphenol-Formaldehyd-Kondensat mit einem Erweichungspunkt von 80 bis 85 °C |
| E-5/3 | Naphthochinon-(1,2)-diazid-(2)-5-sulfonsäure-4-Methylphenylester |
| E-5/4 | Naphthochinon-(1,2)-diazid-(2)-5-sulfonsäure-phenylester. |

Farbstoffe F

Bei F/1 - F/4 handelt es sich jeweils um Triphenylmethan-Farbstoffe (C.I. = Colour Index-Nummer)

F/1 = Flexoviolett 615, C.I. 42 555
F/2 = Basonylviolett 600, C.I. 42 535
F/3 = Basonylblau 639, C.I. 42 595
F/4 = Kristallviolett F10B, C.I. 42 557
F/5 = Diethylaminoazobenzol (lichtempfindlich)

Säurespender S

S/1 = 2-Trichlormethyl-5-(ß-(2'-benzofuranyl)vinyl)-1,3,4-oxdiazol
S/2 = 2-(4-Methoxyphenyl)-4,6-bis-trichlormethyl-1,3,5-triazin
S/3 = 2-(4-Methoxy-naphth-1-yl)-4,6-bis-trichlormethyl-1,3,5-triazin
S/4 = 4-Phenylamino-benzol-diazonium-tetrafluoroborat
S/5 = 4-(4'-Methylphenylthio)-2,5-diethoxybenzol-diazonium-hexafluorophosphat

Hilfsstoffe H

H/1 = Glutarsäureanhydrid (zur Verbesserung der Entwickelbarkeit)

Lösungsmittel L

- L/1 Ethylenglykolmonomethylether
- L/2 Aceton/Propylenglykolmonomethylether (1:4)
- L/3 Propylenglykolmonomethylether
- L/4 Aceton/Propylenglykolmonomethylether (1:1).

Tabelle

| Bsp. Nr. | Bindemittel B | Menge [g] | Ester E-4 | Menge [g] | Ester E-5 | Menge [g] | strahlungsempfindliches Farbstoffsystem: Farbstoff F | Menge [g] | Säurespender S | Menge [g] | Hilfsstoff H | Menge [g] | Lösungsmittel L |
|---|---|---|---|---|---|---|---|---|---|---|---|---|---|
| 1 | B/1 | 74 | E-4/1 | 22 | E-5/1 | 0,95 | F/1 | 1 | S/1 | 0,60 | H/1 | 0,50 | L/1 |
| | | | | | E-5/2 | 0,95 | | | | | | | |
| 2 | B/1 | 57 | E-4/1 | 21 | E-5/1 | 1,30 | F/2 | 1,40 | S/2 | 1,90 | - | | L/2 |
| | B/2 | 15 | | | E-5/2 | 1 | | | S/5 | 1,40 | | | |
| 3 | B/1 | 74 | E-4/1 | 22 | E-5/2 | 1,40 | F/1 | 1 | S/3 | 0,60 | H/1 | 0,40 | L/2 |
| | | | | | | | | | S/1 | 1,40 | | | |
| 4 | B/1 | 71 | E-4/1 | 20 | E-5/1 | 1,40 | F/2 | 1,40 | S/1 | 1,80 | H/1 | 2 | L/1 |
| | | | | | E-5/2 | 1 | | | S/5 | 1,40 | | | |
| 5 | B/1 | 57 | E-4/1 | 21 | E-5/1 | 1,30 | F/2 | 1,40 | S/1 | 1,90 | - | | L/1 |
| | B/3 | 15 | | | E-5/2 | 1 | | | S/5 | 1,40 | | | |
| 6 | B/1 | 72,75 | E-4/1 | 17 | - | | F/3 | 0,50 | - | | - | | L/3 |
| | | | E-4/2 | 9 | | | F/5 | 0,75 | | | | | |
| 7 | B/4 | 75,40 | E-4/1 | 18 | E-5/1 | 1 | F/1 | 1 | S/1 | 0,60 | - | | L/3 |
| | | | E-4/2 | 4 | | | | | | | | | |

Tabelle (Forts.)

| Bsp. Nr. | Bindemittel B | Menge [g] | Ester E-4 | Menge [g] | Ester E-5 | Menge [g] | strahlungsempfindliches Farbstoffsystem: Farbstoff F | Menge [g] | Säurespender S | Menge [g] | Hilfsstoff H | Menge [g] | Lösungsmittel L |
|---|---|---|---|---|---|---|---|---|---|---|---|---|---|
| 8 | B/4 | 74 | E-4/1 | 20 | E-5/3 | 0,95 | F/1 | 1 | S/1 | 0,60 | - | | L/3 |
| | | | E-4/2 | 2,95 | | | | | | | | | |
| 9 | B/1 | 60 | E-4/1 | 20 | E-5/2 | 1,20 | F/2 | 1,30 | S/1 | 1,40 | H/1 | 0,80 | L/4 |
| | B/5 | 13 | | | E-5/4 | 1,20 | | | S/5 | 1,10 | | | |
| 10 | B/1 | 49 | E-4/1 | 25 | | - | F/1 | 1 | S/2 | 0,80 | H/1 | 0,70 | L/4 |
| | B/6 | 20 | E-4/2 | 3,50 | | | | | | | | | |
| 11 | B/7 | 61 | E-4/1 | 35 | E-5/1 | 1 | F/1 | 1 | S/1 | 0,60 | H/1 | 0,40 | L/3 |
| | | | | | E-5/2 | 1 | | | | | | | |
| 12 | B/7 | 53 | E-4/1 | 21 | E-5/1 | 1 | F/1 | 1 | S/2 | 0,80 | H/1 | 0,70 | L/2 |
| | B/8 | 21 | E-4/2 | 1,50 | | | | | | | | | |
| 13 | B/4 | 37 | E-4/1 | 20 | E-5/1 | 0,95 | F/1 | 1 | S/1 | 0,80 | - | | L/2 |
| | B/7 | 37 | E-4/2 | 2,95 | | | | | | | | | |
| 14 | B/7 | 55,50 | E-4/1 | 20 | E-5/3 | 1 | F/1 | 1 | S/1 | 0,60 | H/1 | 0,40 | L/2 |
| | B/9 | 18,50 | E-4/2 | 3 | | | | | | | | | |

Tabelle (Forts.)

| Bsp. Nr. | Bindemittel B | Menge [g] | Ester E-4 | Menge [g] | Ester E-5 | Menge [g] | strahlungsempfindliches Farbstoffsystem: Farbstoff F | Menge [g] | Säurespender S | Menge [g] | Hilfsstoff H | Menge [g] | Lösungsmittel L |
|---|---|---|---|---|---|---|---|---|---|---|---|---|---|
| 15 | B/7 | 37 | E-4/1 | 20 | E-5/1 | 1 | F/1 | 1 | S/1 | 0,60 | H/1 | 0,40 | L/2 |
| | B/10 | 37 | E-4/2 | 3 | | | | | | | | | |
| 16 | B/4 | 16,25 | E-4/1 | 16,25 | - | | F/1 | 0,40 | S/2 | 0,65 | - | | L/2 |
| | B/7 | 50 | E-4/2 | 16,25 | | | F/3 | 0,20 | | | | | |
| 17 | B/1 | 80 | E-4/2 | 18 | - | | F/3 | 0,33 | S/1 | 1,80 | - | | L/4 |
| | | | | | | | F/4 | 0,67 | | | | | |
| 18 | - | | E-4/3 | 96 | - | | F/1 | 1 | S/2 | 2 | - | | L/2 |
| | | | | | | | F/3 | 1 | | | | | |
| 19 | - | | E-4/4 | 94 | E-5/1 | 1 | F/1 | 1,70 | S/1 | 1,50 | H/1 | 0,60 | L/2 |
| | | | | | E-5/2 | 1,20 | | | | | | | |
| 20 | B/7 | 10 | E-4/3 | 88 | - | | F/1 | 1,10 | S/1 | 0,60 | H/1 | 0,30 | L/2 |
| 21 | B/4 | 10 | E-4/3 | 88 | - | | F/1 | 1,10 | S/1 | 0,60 | H/1 | 0,30 | L/2 |
| 22 | B/1 | 10 | E-4/4 | 85,30 | - | | F/2 | 1,60 | S/2 | 1,70 | - | | L/2 |
| | | | | | | | | | S/5 | 1,40 | | | |

## Patentansprüche

1. Verfahren zur Herstellung negativer Reliefkopien durch bildmäßige Belichtung einer Aufzeichnungsplatte aus einem Träger und einer darauf aufgebrachten lichtempfindlichen Schicht, die als lichtempfindliche Verbindungen Ester der 1,2-Naphthochinon-2-diazid-4- und/oder 5-sulfonsäure oder -carbonsäure

enthalten, Erhitzen der belichteten Platte, vollflächiges Belichten der Platte und Entwickeln der Reliefkopie durch Herauslösen der alkalilöslichen Bestandteile aus der Aufzeichnungsschicht mittels einer wäßrig-alkalischen Entwicklerlösung, dadurch gekennzeichnet, daß die lichtempfindliche Schicht der Aufzeichnungsplatte ein Umsetzungsprodukt aus

a) 50 bis 99 Gew.-% eines oligomeren oder polymeren Kondensationsproduktes aus

$a_1$) 0,5 bis 1 mol eines alkyl- und/oder alkoxysubstituierten ein- bis dreiwertigen Hydroxybenzols,
$a_2$) 0 bis 0,5 mol Phenol und
$a_3$) 0,5 bis 1,5 mol einer $C_1$-$C_{12}$-Carbonylverbindung,

wobei die Summe der Mengen von $a_1$) und $a_2$) 1 mol beträgt, und

b) 1 bis 50 Gew.-% 1,2-Naphthochinon-2-diazid-4-sulfonsäure oder -carbonsäure oder einem funktionellen Derivat dieser Säuren,

wobei bis zu 20 Gew.-% dieser Verbindungen durch die entsprechenden Ester der 5-Sulfon- oder -Carbonsäure ersetzt sein können,

enthält.

**2.** Verfahren nach Anspruch 1, dadurch gekennzeichnet, daß die Komponente $a_1$) p-Kresol oder p-tert.-Butylphenol ist.

**3.** Verfahren nach Anspruch 1 oder 2, dadurch gekennzeichnet, daß die Komponente $a_3$) Formaldehyd ist.

**4.** Verfahren nach den Ansprüchen 1 bis 3, dadurch gekennzeichnet, daß die Menge der Komponente $a_3$) 0,8 bis 1,2 mol beträgt.

**5.** Lichtempfindliches Aufzeichnungsmaterial, enthaltend als wirksame lichtempfindliche Komponente 80 bis 100 Gew.-% eines Umsetzungsproduktes gemäß Anspruch 1 und 0 bis 20 Gew.-% eines alkalilöslichen Bindemittels sowie darüber hinaus weitere für die Herstellung von Reliefkopien übliche Hilfsstoffe in den hierfür gebräuchlichen Mengen.